# EUROPEAN PATENT APPLICATION

(11) **EP 4 425 569 A1**
(43) Date of publication of application: **04.09.2024**
(21) Application number: 24157587.7
(22) Date of filing: 14.02.2024
(51) Int. Cl.: H01L 29/786, H01L 27/02, H01L 29/775

(54) **DEVICE FOR ELECTROSTATIC DISCHARGE PROTECTION USING BIPOLAR JUNCTION TRANSISTOR**

(30) Priority: 20.02.2023 KR 20230022448; 16.03.2023 KR 20230034575; 09.06.2023 KR 20230074381
(71) Applicant: Samsung Electronics Co., Ltd., Suwon-si, Gyeonggi-do 16677 (KR)
(72) Inventor: KWON, Hyukhoon, Suwon-si, Gyeonggi-do 16677 (KR); JEON, Chanhee, Suwon-si, Gyeonggi-do 16677 (KR); DO, Kyoungil, Suwon-si, Gyeonggi-do 16677 (KR); LEE, Mijin, Suwon-si, Gyeonggi-do 16677 (KR)
(74) Representative: Kuhnen & Wacker Patent- und Rechtsanwaltsbüro PartG mbB

(57) **Abstract**

Provided is a device including a first well having a first conductivity type, a first gate electrode on the first well, a first region and a second region each having a second conductivity type on the first well with the first gate electrode disposed therebetween, a third region having the second conductivity type on the first well, and a fourth region having the first conductivity type on the first well. The first gate electrode and the first region are electrically connected to a first node, and the third region is electrically connected to a second node.

## Description

### CROSS-REFERENCE TO RELATED APPLICATIONS

This application claims priority under 35 U.S.C. §119 to Korean Patent Application No. 10-2023-0022448 filed on February 20, 2023, Korean Patent Application No. 10-2023-0034575 filed on March 16, 2023, and Korean Patent Application No. 10-2023-0074381 filed on June 9, 2023, the disclosures of which are incorporated by reference herein in their entirety.

### TECHNICAL FIELD

Embodiments of the inventive concept relate to electrostatic discharge (ESD) protection, and more particularly, to a device for ESD protection using a bipolar junction transistor (BJT).

### DISCUSSION OF RELATED ART

Electrostatic discharge (ESD) may cause an integrated circuit to malfunction, or may even damage the integrated circuit. Accordingly, an integrated circuit may include a component for ESD protection, and the component for ESD protection may protect an internal circuit from ESD generated outside of the integrated circuit. Due to the development of semiconductor processes, the size of elements included in an integrated circuit may be reduced, the operating voltage of elements included in an integrated circuit may be reduced to reduce power consumption, and the frequency of signals input to or output from an integrated circuit may be increased to achieve high performance. Accordingly, it may be desirable for a component for ESD protection to meet various requirements.

### SUMMARY

Embodiments of the inventive concept provide a device providing electrostatic discharge (ESD) protection with high efficiency.

According to an aspect of the inventive concept, there is provided a device including a first well having a first conductivity type, a first gate electrode extending in a first horizontal direction on the first well, a first region and a second region each having a second conductivity type and spaced apart from each other in a second horizontal direction on the first well with the first gate electrode disposed therebetween, the second horizontal direction crossing the first horizontal direction, a third region having the second conductivity type and spaced apart from the second region in the second horizontal direction on the first well, and a fourth region having the first conductivity type and spaced apart from the third region in the second horizontal direction on the first well. The first gate electrode and the first region are electrically connected to a first node, and the third region is electrically connected to a second node.

According to an aspect of the inventive concept, there is provided a device including a first n-channel field effect transistor (NFET) including a first gate, a first drain, and a first source, and a first NPN bipolar transistor including a first base, a first emitter, and a first collector. The first gate and the first drain are electrically connected to a first node, the first emitter is electrically connected to a second node, and the first source and the first collector correspond to one first n-type region.

According to an aspect of the inventive concept, there is provided a device including a first NFET and a second NFET each having a gate electrically connected to a first node and sharing a drain electrically connected to the first node, and a first NPN bipolar transistor and a second NPN bipolar transistor each having an emitter electrically connected to a second node. A source of the first NFET and the emitter of the first NPN bipolar transistor correspond to one first n-type region, and a source of the second NFET and the emitter of the second NPN bipolar transistor correspond to one second n-type region.

### BRIEF DESCRIPTION OF THE DRAWINGS

The above and other features of the inventive concept will become more apparent by describing in detail embodiments thereof with reference to the accompanying drawings, in which:
FIG. 1 is a block diagram illustrating a device according to an embodiment;
FIG. 2 is a circuit diagram illustrating a device for electrostatic discharge (ESD) protection according to an embodiment;
FIGs. 3A to 3D are diagrams illustrating examples of a field effect transistor (FET) according to embodiments;
FIG. 4 is a diagram illustrating a layout of a device according to an embodiment;
FIG. 5 is a circuit diagram illustrating a device according to an embodiment;
FIG. 6 is a diagram illustrating a layout of a device according to an embodiment;
FIG.7 is a diagram illustrating a layout of a device according to an embodiment;
FIG. 8 is a circuit diagram illustrating a device for ESD protection according to an embodiment;
FIG. 9 is a diagram illustrating a layout of a device according to an embodiment;
FIG. 10 is a circuit diagram illustrating a device according to an embodiment;
FIG. 11 is a circuit diagram illustrating a device according to an embodiment;
FIG. 12 is a diagram illustrating a layout of a device according to an embodiment;
FIG. 13 is a circuit diagram illustrating a device according to an embodiment; and
FIG. 14 is a diagram illustrating a layout of a device according to an embodiment.

### DETAILED DESCRIPTION OF THE EMBODIMENTS

Embodiments of the inventive concept will be described more fully hereinafter with reference to the accompanying drawings. Like reference numerals may refer to like elements throughout the accompanying drawings.

It will be understood that the terms "first," "second," "third," etc. are used herein to distinguish one element from another, and the elements are not limited by these terms. Thus, a "first" element in an embodiment may be described as a "second" element in another embodiment.

As used herein, the singular forms "a", "an" and "the" are intended to include the plural forms as well, unless the context clearly indicates otherwise.

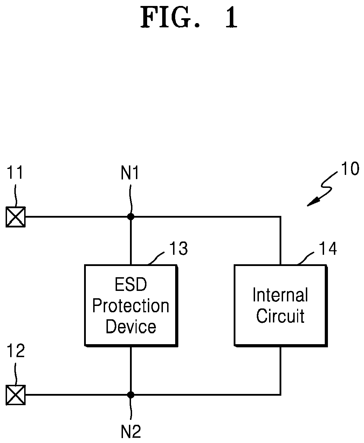

FIG. 1 is a block diagram illustrating a device 10 according to an embodiment. In some embodiments, the device 10 may include an integrated circuit manufactured by a semiconductor process. For example, the device 10 may be a chip or die, or may be a semiconductor package including at least one chip or die. As illustrated in FIG. 1, the device 10 may include a first pad 11, a second pad 12, an electrostatic discharge (ESD) protection device 13, and an internal circuit 14. Herein, the ESD protection device 13 or the device 10 including the ESD protection device 13 may be referred to as a device for ESD protection or a device that provides ESD protection.

The first pad 11 and the second pad 12 may be exposed to the outside of the device 10, and the first pad 11 and/or the second pad 12 may be used to transmit signals or power. For example, the first pad 11 may be one of an input pad that receives signals from the outside of the device 10, an output pad that outputs signals generated by the device 10 to the outside of the device 10, and an input/output pad that receives or outputs signals according to a mode. In addition, the second pad 12 may be a power pad that receives a positive supply voltage and/or a negative supply voltage and provides power to the device 10. As illustrated in FIG. 1, the first pad 11 may be connected to a first node N1 and the second pad 12 may be connected to a second node N2.

Herein, when two or more components are electrically connected to each other, the two or more components may be simply referred to as being connected to each other. For example, when two components are connected to each other through a resistor (e.g., a parasitic resistor), the two components may be referred to as being electrically connected to each other. In addition, when two or more components are directly connected to each other, the two or more components may be referred to as coupled to each other.

When ESD occurs between the first pad 11 and the second pad 12, the ESD protection device 13 may form a low-impedance discharge path between the first pad 11 and the second pad 12. Accordingly, the internal circuit 14 may be protected from the ESD by the ESD protection device 13. Hereinafter, it is assumed that positive ESD occurs between the first pad 11 and the second pad 12, that is, between the first node N1 and the second node N2, and thus, the ESD protection device 13 forms a low-impedance path through which a current flows from the first node N1 to the second node N2. However, embodiments are not limited thereto.

Due to the development of semiconductor processes, the size of elements included in the internal circuit 14 may be reduced, and a junction depth and the thickness of a gate oxide may be reduced. In addition, the operating voltage of the internal circuit 14, that is, the voltage difference between a positive supply voltage and a negative supply voltage, may be reduced, and the frequency of signals input or output through the first pad 11 and/or the second pad 12 may be increased. As a result, lower power consumption and high operating speed may be achieved. Accordingly, it may be desirable for the ESD protection device 13 to meet more stringent requirements, for example, high current driving capability, low triggering voltage, low leakage current, low capacitance, and the like.

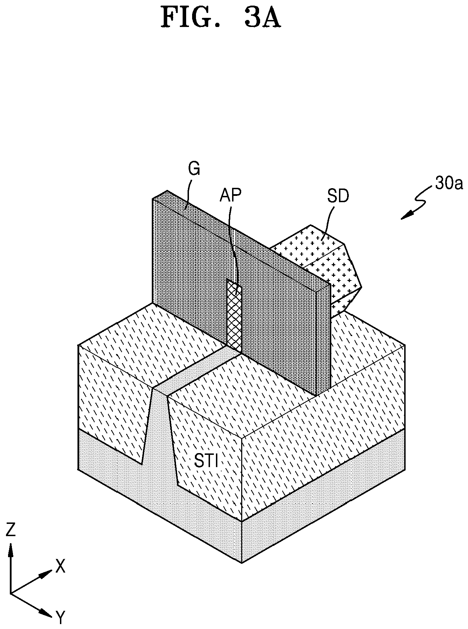

In some embodiments, when the internal circuit 14 includes a three-dimensional element, as described below with reference to FIGS. 3A to 3D, it may be desirable for the ESD protection device 13 to be implemented in a limited area and/or a limited process. Accordingly, the ESD protection device 13 may include a plurality of circuits connected in parallel to each other between the first node N1 and the second node N2. The plurality of circuits may have variations, and currents may concentrate in some of the plurality of circuits when ESD occurs. Accordingly, ESD protection may not be properly performed or some of the circuits may be permanently damaged, and thus, the ESD protection function of the ESD protection device 13 may be lost.

As described below with reference to the drawings, the ESD protection device 13 may include a bipolar junction transistor (BJT) disposed between the first node N1 and the second node N2 and may provide a resistor connected in series to a PN junction of the BJT. Accordingly, uniformity among the plurality of circuits included in the ESD protection device 13 may be achieved, and the ESD protection device 13 may provide high reliability and robustness.

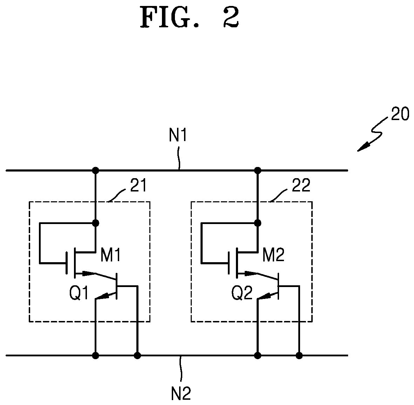

FIG. 2 is a circuit diagram illustrating a device 20 for ESD protection according to an embodiment. For example, FIG. 2 illustrates an example of the ESD protection device 13 of FIG. 1. As described above with reference to FIG. 1, the device 20 may include a plurality of circuits connected in parallel to each other between the first node N1 and the second node N2. However, the example is not limited thereto, and the device 20 for ESD protection may only include one circuit between the first node N1 and the second node N2 (for example, only include one of a first circuit 21 and a second circuit 22). For example, as illustrated in FIG. 2, the device 20 may include a first circuit 21 and a second circuit 22 connected in parallel to each other between the first node N1 and the second node N2. In some embodiments, the device 20 may further include at least one circuit connected in parallel to the first circuit 21 and the second circuit 22. In some embodiments, the first circuit 21 and the second circuit 22 may be designed to have the same structure.

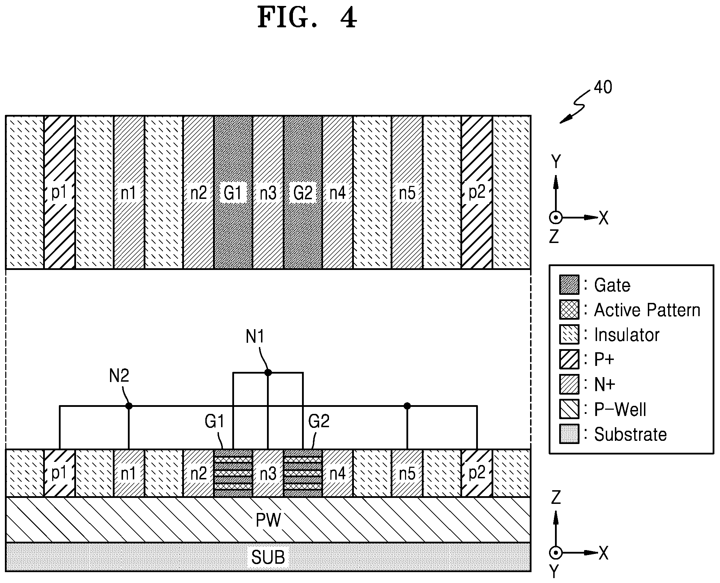

The first circuit 21 may include a first n-channel field effect transistor (NFET) M1 and a first NPN BJT Q1. As illustrated in FIG. 2, the first NFET M1 may include a gate and a drain, each connected to the first node N1, and the first NPN BJT Q1 may include a base and an emitter, each connected to the second node N2. In some embodiments, as described below with reference to FIG. 4 and the like, a source of the first NFET M1 and a collector of the first NPN BJT Q1 may correspond to one region, that is, one n-type doped region. When ESD occurs between the first node N1 and the second node N2, the voltages of the drain and the gate of the first NFET M1 may increase, and thus, the voltage of the source of the first NFET M1, that is, the collector of the first NPN BJT Q1, may increase. An avalanche breakdown may occur at a PN junction between the collector and the base of the first NPN BJT Q1, and in this case, the source of the first NFET M1 (e.g., the collector of the first NPN BJT Q1), as well as the gate thereof, may provide ballistic resistance. A hole current generated by the avalanche breakdown may be developed through a base current of the first NPN BJT Q1, and the first NPN BJT Q1 may operate as the voltage of the base thereof increases.

The second circuit 22 may include a second NFET M2 and a second NPN BJT Q2. As illustrated in FIG. 2, the second NFET M2 may include a gate and a drain, each connected to the first node N1, and the second NPN BJT Q2 may include a base and an emitter, each connected to the second node N2. In some embodiments, as described below with reference to FIG. 4 and the like, a source of the second NFET M2 and a collector of the second NPN BJT Q2 may correspond to one region, that is, one n-type doped region. When ESD occurs between the first node N1 and the second node N2, the voltages of the drain and the gate of the second NFET M2 may increase, and thus, the voltage of the source of the second NFET M2, that is, the collector of the second NPN BJT Q2, may increase. An avalanche breakdown may occur at a PN junction between the collector and the base of the second NPN BJT Q2, and in this case, the source of the second NFET M2 (e.g., the collector of the second NPN BJT Q2), as well as the gate thereof, may provide ballistic resistance. A hole current generated by the avalanche breakdown may be developed through a base current of the second NPN BJT Q2, and the second NPN BJT Q2 may operate as the voltage of the base thereof increases.

Due to ballistic resistance, when ESD occurs, ESD currents respectively flowing into the first circuit 21 and the second circuit 22 from the first node N1 may be restricted. Accordingly, a variation between the ESD currents respectively flowing into the first circuit 21 and the second circuit 22 may be reduced, and the ESD currents may be prevented from being concentrated in one of the first circuit 21 and the second circuit 22. Accordingly, uniformity of the ESD currents may be achieved, and high reliability and robustness of the device 20 may be achieved.

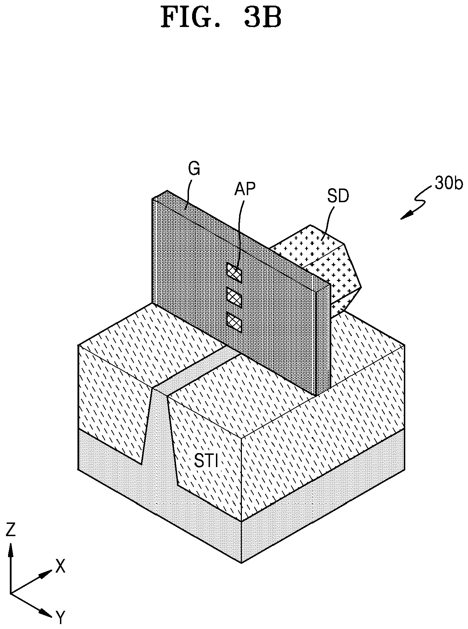

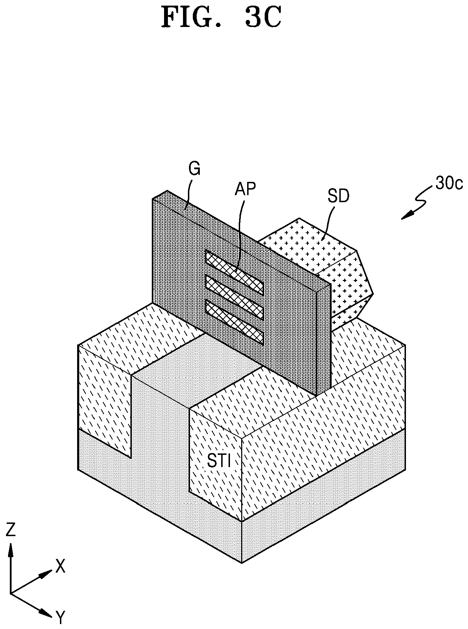

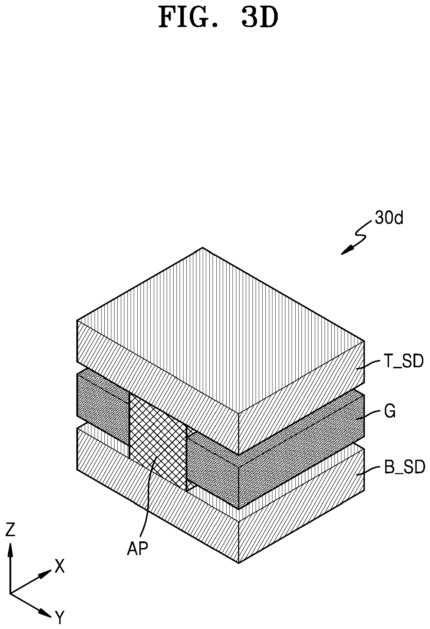

FIGS. 3A to 3D are diagrams illustrating examples of a field effect transistor (FET) according to embodiments. For example, FIG. 3A illustrates a fin field effect transistor (FinFET) 30a, FIG. 3B illustrates a gate-all-around field effect transistor (GAAFET) 30b, FIG. 3C illustrates a multi-bridge channel field effect transistor (MBCFET) 30c, and FIG. 3D illustrates a vertical field effect transistor (VFET) 30d. For convenience of illustration, FIGS. 3A to 3C each illustrate an example in which one of three source/drain regions is removed, and FIG. 3D illustrates a cross-section of the VFET 30d, taken along a plane which is parallel to a plane including a Y-axis and a Z-axis and passes through a channel of the VFET 30d.

Referring to FIG. 3A, the FinFET 30a may be formed by an active pattern AP, which has a fin shape and extends in an X-axis direction between shallow trench isolations STI, and a gate electrode G extending in a Y-axis direction. A source/drain region SD may be formed at each of both sides of the gate electrode G, and thus, a source and a drain may be spaced apart from each other in the X-axis direction. An insulation layer may be formed between a channel and the gate electrode G. In some embodiments, the FinFET 30a may be formed by a plurality of active patterns AP, which are spaced apart from each other in the Y-axis direction, and the gate electrode G.

Referring to FIG. 3B, the GAAFET 30b may be formed by active patterns AP (e.g., nanowires), which are spaced apart from each other in a Z-axis direction and extend in an X-axis direction, and a gate electrode G extending in a Y-axis direction. A source/drain region SD may be formed at each of both sides of the gate electrode G, and thus, a source and a drain may be spaced apart from each other in the X-axis direction. An insulation layer may be formed between a channel and the gate electrode G. The number of nanowires included in the GAAFET 30b is not limited to the illustration of FIG. 3B.

Referring to FIG. 3C, the MBCFET 30c may be formed by active patterns AP (e.g., nanosheets), which are spaced apart from each other in a Z-axis direction and extend in an X-axis direction, and a gate electrode G extending in a Y-axis direction. A source/drain region SD may be formed at each of both sides of the gate electrode G, and thus, a source and a drain may be spaced apart from each other in the X-axis direction. An insulation layer may be formed between a channel and the gate electrode G. The number of nanosheets included in the MBCFET 30c is not limited to the illustration of FIG. 3C.

Referring to FIG. 3D, the VFET 30d may include a top source/drain T_SD and a bottom source/drain B_SD, which are spaced apart from each other in a Z-axis direction with a channel disposed therebetween. The VFET 30d may include a gate electrode G surrounding the perimeter of the channel between the top source/drain T_SD and the bottom source/drain B_SD. An insulation layer may be formed between the channel and the gate electrode G.

Hereinafter, a device including the GAAFET 30b or the MBCFET 30c will be mainly described, but elements included in the device are not limited to the embodiments of FIGS. 3A to 3D. For example, the device may include a ForkFET having a structure in which nanosheets for a P-type transistor are separated from nanosheets for an N-type transistor by a dielectric wall, and thus, the N-type transistor and the P-type transistor are closer to each other. In addition, the device may include an FET such as, for example, a complementary FET (CFET), a negative CFET (NCFET), a carbon nanotube (CNT) FET, or the like.

Herein, a Y-axis direction and an X-axis direction may be respectively referred to as a first horizontal direction and a second horizontal direction, and a Z-axis direction may be referred to as a vertical direction. A plane including the X-axis and the Y-axis may be referred to as a horizontal plane, a first component disposed in a +Z direction relative to a second component may be referred to as being disposed above the second component, and a first component disposed in a -Z direction relative to a second component may be referred to as being disposed below the second component. In addition, the area of a component may refer to the size occupied by the component on a plane parallel to the horizontal plane, and the width of a component may refer to the length of the component in a direction perpendicular to a direction in which the component extends. A surface exposed in the +Z direction may be referred to as a top surface, a surface exposed in the -Z direction may be referred to as a bottom surface, and a surface exposed in a ±X direction or a ±Y direction may be referred to as a side surface. A pattern including a conductive material, such as a pattern of a wiring layer, may be referred to as a conductive pattern, or may be simply referred to as a pattern. In the drawings provided herein, only some layers may be shown for convenience of illustration.

FIG. 4 is a diagram illustrating a layout of a device according to an embodiment. For example, FIG. 4 illustrates a plan view and a cross-sectional view of a layout 40 including the first circuit 21 and the second circuit 22 of FIG. 2. For convenience of illustration, structures for connecting p+ regions, n+ regions, and gates to each other, for example, contacts, vias, and conductive patterns, are omitted. Hereinafter, FIG. 4 will be described with reference to FIG. 2.

Referring to FIG. 4, a p-well PW may be disposed in a substrate SUB. A first p+ region p1, first to fifth n+ regions n1 to n5, and a second p+ region p2 may be sequentially disposed in an X-axis direction on the p-well PW. In addition, a first gate G1 may be formed between the second n+ region n2 and the third n+ region n3, and a second gate G2 may be formed between the third n+ region n3 and the fourth n+ region n4. As illustrated in FIG. 4, the layout 40 may include three active patterns (e.g., three nanosheets) passing through the first gate G1 in the X-axis direction and connected to the second n+ region n2 and the third n+ region n3, and may include three active patterns (e.g., three nanosheets) passing through the second gate G2 in the X-axis direction and connected to the third n+ region n3 and the fourth n+ region n4. The number of active patterns passing through a gate electrode is not limited to the illustration of FIG. 4.

The first p+ region p1, the first to fifth n+ regions n1 to n5, and the second p+ region p2 may extend in a Y-axis direction, and the first gate G1 and the second gate G2 may also extend in the Y-axis direction. An insulator may be disposed in a portion from which a gate is removed between doped regions (e.g., n+ regions and p+ regions) on the p-well PW. For example, an insulator may be disposed between the first n+ region n1 and the second n+ region n2. In some embodiments, a gate disposed between doped regions may be removed by a diffusion break. For example, as illustrated in FIG. 4, a gate may be removed by a single diffusion break (SDB) having a width corresponding to the width of the gate. In some embodiments, the gate may be removed by a double diffusion break (DDB) having a width corresponding to one doped region and gate electrodes disposed adjacent thereto. Accordingly, the layout 40 of FIG. 4 may be formed by the same process as that of an internal circuit. In an example, a first diffusion break may extending in the Y-axis direction between the second n+ region n2 and the first n+ region n1 on the p-well PW, and a second diffusion break may extending in the Y-axis direction between the first n+ region n1 and the first p+ region p1 on the p-well PW. In another example, the first diffusion break may extending in the Y-axis direction between the second n+ region n2 and the first n+ region n1 on the p-well PW, and the second diffusion break may extending in the Y-axis direction between the second n+ region n2 and the first p+ region p1 on the p-well PW.

The first NFET M1 of FIG. 2 may correspond to the first gate G1, the second n+ region n2, and the third n+ region n3, and the first NPN BJT Q1 of FIG. 2 may correspond to the p-well PW, the first p+ region p1, the first n+ region n1, and the second n+ region n2. For example, the first gate G1 and the third n+ region n3, which are connected to the first node N1, may respectively correspond to the gate and the drain of the first NFET M1, and the second n+ region n2 may correspond to the source of the first NFET M1. In addition, the first n+ region n1 connected to the second node N2 may correspond to the emitter of the first NPN BJT Q1, the p-well PW, which is connected to the second node N2 through the first p+ region p1, may correspond to the base of the first NPN BJT Q1, and the second n+ region n2 may correspond to the collector of the first NPN BJT Q1. Accordingly, the second n+ region n2 may correspond to the source of the first NFET M1 and the collector of the first NPN BJT Q1 and may be shared by the first NFET M1 and the first NPN BJT Q1.

The second NFET M2 of FIG. 2 may correspond to the second gate G2, the third n+ region n3, and the fourth n+ region n4, and the second NPN BJT Q2 of FIG. 2 may correspond to the p-well PW, the fourth n+ region n4, the fifth n+ region n5, and the second p+ region p2. For example, the second gate G2 and the third n+ region n3, which are connected to the first node N1, may respectively correspond to the gate and the drain of the second NFET M2, and the fourth n+ region n4 may correspond to the source of the second NFET M2. In addition, the fifth n+ region n5 connected to the second node N2 may correspond to the emitter of the second NPN BJT Q2, the p-well PW, which is connected to the second node N2 through the second p+ region p2, may correspond to the base of the second NPN BJT Q2, and the fourth n+ region n4 may correspond to the collector of the second NPN BJT Q2. Accordingly, the fourth n+ region n4 may correspond to the source of the second NFET M2 and the collector of the second NPN BJT Q2 and may be shared by the second NFET M2 and the second NPN BJT Q2.

Herein, an n+ region may have an n-type dopant concentration that is higher than that of an n-well, and a p+ region may have a p-type dopant concentration that is higher than that of a p-well. In some embodiments, a p-well and/or an n-well may be disposed in a deep n-well, and the deep n-well may have an n-type dopant concentration that is similar to or lower than that of the n-well. In an example, the p-well and the p+ region may have a same conductivity type, the n-well and the n+ region may have a same conductivity type, and the p-well and the n-well may have different conductivity types.

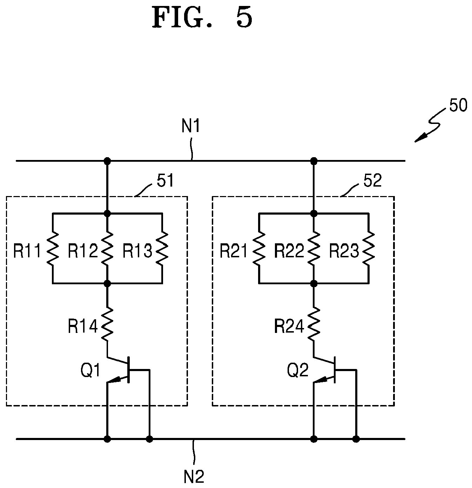

FIG. 5 is a circuit diagram illustrating a device 50 according to an embodiment. For example, the circuit diagram of FIG. 5 illustrates an equivalent circuit corresponding to the layout 40 of FIG. 4. As illustrated in FIG. 5, the device 50 may include a first circuit 51 and a second circuit 52 connected in parallel to each other between the first node N1 and the second node N2. Hereinafter, FIG. 5 will be described with reference to FIGS. 2 and 4.

The first circuit 51 may include resistors R11 to R14 and the first NPN BJT Q1. The resistors R11 to R14 may include three resistors R11, R12 and R13 connected in parallel to each other and a resistor R14 connected in series to the first NPN BJT Q1. The three resistors R11 to R13 connected in parallel to each other may respectively correspond to the three active patterns passing through the first gate G1, and the resistor R14 may correspond to the second n+ region n2. As described above with reference to FIG. 2, the first NFET M1 of FIG. 2 may provide ballistic resistance corresponding to the resistors R11 to R14.

The second circuit 52 may include resistors R21 to R24 and the second NPN BJT Q2. The resistors R21 to R24 may include three resistors R21, R22 and R23 connected in parallel to each other and a resistor R24 connected in series to the second NPN BJT Q2. The three resistors R21 to R23 connected in parallel to each other may respectively correspond to the three active patterns passing through the second gate G2, and the resistor R24 may correspond to the fourth n+ region n4. As described above with reference to FIG. 2, the second NFET M2 of FIG. 2 may provide ballistic resistance corresponding to the resistors R21 to R24.

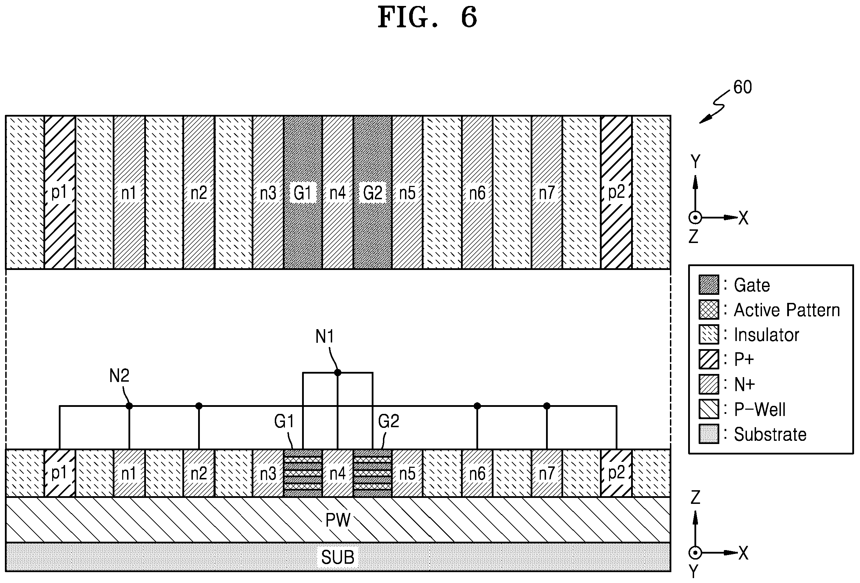

FIG. 6 is a diagram illustrating a layout of a device according to an embodiment. For example, FIG. 6 illustrates a plan view and a cross-sectional view of a layout 60 including the first circuit 21 and the second circuit 22 of FIG. 2. For convenience of illustration, structures for connecting p+ regions, n+ regions, and gates to each other, for example, contacts, vias, and conductive patterns, are omitted. Hereinafter, FIG. 6 will be described with reference to FIG. 2.

Referring to FIG. 6, a p-well PW may be disposed in a substrate SUB. A first p+ region p1, first to seventh n+ regions n1 to n7, and a second p+ region p2 may be sequentially disposed in an X-axis direction on the p-well PW. In addition, a first gate G1 may be formed between the third n+ region n3 and the fourth n+ region n4, and a second gate G2 may be formed between the fourth n+ region n4 and the fifth n+ region n5. As illustrated in FIG. 6, the layout 60 may include three active patterns (e.g., three nanosheets) passing through the first gate G1 in the X-axis direction and connected to the third n+ region n3 and the fourth n+ region n4, and may include three active patterns (e.g., three nanosheets) passing through the second gate G2 in the X-axis direction and connected to the fourth n+ region n4 and the fifth n+ region n5. The number of active patterns passing through a gate electrode is not limited to the illustration of FIG. 6.

The first p+ region p1, the first to seventh n+ regions n1 to n7, and the second p+ region p2 may extend in a Y-axis direction, and the first gate G1 and the second gate G2 may also extend in the Y-axis direction. An insulator may be disposed in a portion from which a gate is removed, and for example, an SDB may be disposed between doped regions (e.g., n+ regions and p+ regions) on the p-well PW.

The first NFET M1 of FIG. 2 may correspond to the first gate G1, the third n+ region n3, and the fourth n+ region n4, and the first NPN BJT Q1 of FIG. 2 may correspond to the p-well PW, the first p+ region p1, and the first to third n+ regions n1 to n3. For example, the first gate G1 and the fourth n+ region n4, which are connected to the first node N1, may respectively correspond to the gate and the drain of the first NFET M1, and the third n+ region n3 may correspond to the source of the first NFET M1. In addition, the first n+ region n1 and the second n+ region n2, which are connected to the second node N2, may correspond to the emitter of the first NPN BJT Q1, the p-well PW, which is connected to the second node N2 through the first p+ region p1, may correspond to the base of the first NPN BJT Q1, and the third n+ region n3 may correspond to the collector of the first NPN BJT Q1. Accordingly, the third n+ region n3 may correspond to the source of the first NFET M1 and the collector of the first NPN BJT Q1 and may be shared by the first NFET M1 and the first NPN BJT Q1.

The second NFET M2 of FIG. 2 may correspond to the second gate G2, the fourth n+ region n4, and the fifth n+ region n5, and the second NPN BJT Q2 of FIG. 2 may correspond to the p-well PW, the fifth to seventh n+ regions n5 to n7, and the second p+ region p2. For example, the second gate G2 and the fourth n+ region n4, which are connected to the first node N1, may respectively correspond to the gate and the drain of the second NFET M2, and the fifth n+ region n5 may correspond to the source of the second NFET M2. In addition, the sixth n+ region n6 and the seventh n+ region n7, which are connected to the second node N2, may correspond to the emitter of the second NPN BJT Q2, the p-well PW, which is connected to the second node N2 through the second p+ region p2, may correspond to the base of the second NPN BJT Q2, and the fifth n+ region n5 may correspond to the collector of the second NPN BJT Q2. Accordingly, the fifth n+ region n5 may correspond to the source of the second NFET M2 and the collector of the second NPN BJT Q2 and may be shared by the second NFET M2 and the second NPN BJT Q2.

Compared to the layout 40 of FIG. 4, the layout 60 of FIG. 6 may include additional n+ regions, that is, the second n+ region n2 and the sixth n+ region n6. Accordingly, the emitter of the first NPN BJT Q1 of FIG. 2 may correspond to two n+ regions, that is, the first n+ region n1 and the second n+ region n2, and the emitter of the second NPN BJT Q2 of FIG. 2 may correspond to two n+ regions, that is, the sixth n+ region n6 and the seventh n+ region n7. Due to the increased number of n+ regions, when ESD occurs in the layout 60 of FIG. 6, emitter crowding may be reduced and a high breakdown current, that is, a high ESD current, may be provided. In some embodiments, a layout corresponding to the device 20 of FIG. 2 may include three or more n+ regions corresponding to the emitter of the first NPN BJT Q1 or the emitter of the second NPN BJT Q2.

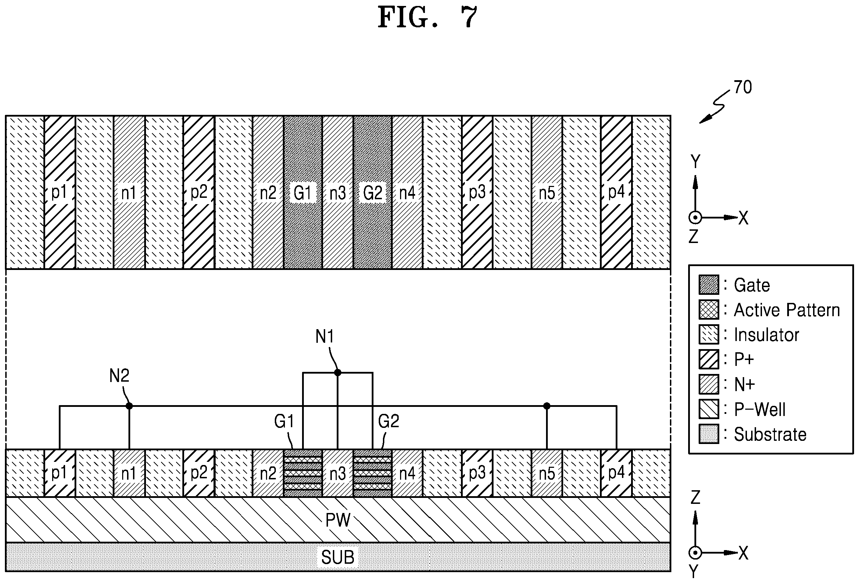

FIG.7 is a diagram illustrating a layout of a device according to an embodiment. For example, FIG. 7 illustrates a plan view and a cross-sectional view of a layout 70 including the first circuit 21 and the second circuit 22 of FIG. 2. For convenience of illustration, structures for connecting p+ regions, n+ regions, and gates to each other, for example, contacts, vias, and conductive patterns, are omitted. Hereinafter, FIG. 7 will be described with reference to FIG. 2.

Referring to FIG. 7, a p-well PW may be disposed in a substrate SUB. A first p+ region p1, a first n+ region n1, a second p+ region p2, second to fourth n+ regions n2 to n4, a third p+ region p3, a fifth n+ region n5, and a fourth p+ region p4 may be sequentially disposed in an X-axis direction on the p-well PW. In addition, a first gate G1 may be formed between the second n+ region n2 and the third n+ region n3, and a second gate G2 may be formed between the third n+ region n3 and the fourth n+ region n4. As illustrated in FIG. 7, the layout 70 may include three active patterns (e.g., three nanosheets) passing through the first gate G1 in the X-axis direction and connected to the second n+ region n2 and the third n+ region n3, and may include three active patterns (e.g., three nanosheets) passing through the second gate G2 in the X-axis direction and connected to the third n+ region n3 and the fourth n+ region n4. The number of active patterns passing through a gate electrode is not limited to the illustration of FIG. 7.

The first p+ region p1, the first n+ region n1, the second p+ region p2, the second to fourth n+ regions n2 to n4, the third p+ region p3, the fifth n+ region n5, and the fourth p+ region p4 may extend in a Y-axis direction, and the first gate G1 and the second gate G2 may also extend in the Y-axis direction. An insulator may be disposed in a portion from which a gate is removed, and for example, an SDB may be disposed between doped regions (e.g., n+ regions and p+ regions) on the p-well PW.

The first NFET M1 of FIG. 2 may correspond to the first gate G1, the second n+ region n2, and the third n+ region n3, and the first NPN BJT Q1 of FIG. 2 may correspond to the p-well PW, the first p+ region p1, the first n+ region n1, the second p+ region p2, and the second n+ region n2. For example, the first gate G1 and the third n+ region n3, which are connected to the first node N1, may respectively correspond to the gate and the drain of the first NFET M1, and the second n+ region n2 may correspond to the source of the first NFET M1. In addition, the first n+ region n1 connected to the second node N2 may correspond to the emitter of the first NPN BJT Q1, the p-well PW, which is connected to the second node N2 through the first p+ region p1, may correspond to the base of the firstNPN BJT Q1, and the second n+ region n2 may correspond to the collector of the first NPN BJT Q1. Accordingly, the second n+ region n2 may correspond to the source of the first NFET M1 and the collector of the first NPN BJT Q1 and may be shared by the first NFET M1 and the first NPN BJT Q1.

The second NFET M2 of FIG. 2 may correspond to the second gate G2, the third n+ region n3, and the fourth n+ region n4, and the second NPN BJT Q2 of FIG. 2 may correspond to the p-well PW, the fourth n+ region n4, the third p+ region p3, the fifth n+ region n5, and the fourth p+ region p4. For example, the second gate G2 and the third n+ region n3, which are connected to the first node N1, may respectively correspond to the gate and the drain of the second NFET M2, and the fourth n+ region n4 may correspond to the source of the second NFET M2. In addition, the fifth n+ region n5 connected to the second node N2 may correspond to the emitter of the second NPN BJT Q2, the p-well PW, which is connected to the second node N2 through the second p+ region p2, may correspond to the base of the second NPN BJT Q2, and the fourth n+ region n4 may correspond to the collector of the second NPN BJT Q2. Accordingly, the fourth n+ region n4 may correspond to the source of the second NFET M2 and the collector of the second NPN BJT Q2 and may be shared by the second NFET M2 and the second NPN BJT Q2.

Compared to the layout 40 of FIG. 4, the layout 70 of FIG. 7 may include additional p+ regions, that is, the second p+ region p2 and the third p+ region p3, on the p-well PW. Accordingly, when ESD occurs, base recombination may be further activated due to the second p+ region p2 in the first NPN BJT Q1. Similarly, when ESD occurs, base recombination may be further activated due to the third p+ region p3 in the second NPN BJT Q2. Accordingly, the hold voltage of a snapback device may be increased, and distortion of signals, deterioration of the device, and/or damage to the device may be prevented. In some embodiments, a layout corresponding to the device 20 of FIG. 2 may include two or more additional p+ regions for activation of base recombination in the first NPN BJT Q1 or the second NPN BJT Q2.

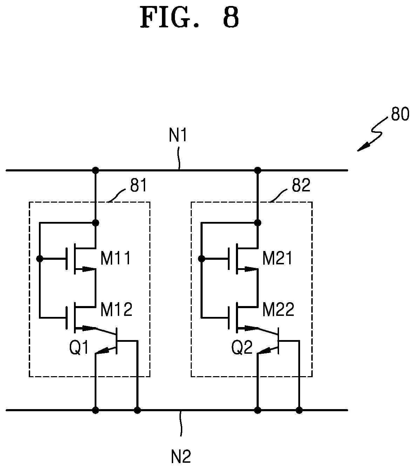

FIG. 8 is a circuit diagram illustrating a device 80 for ESD protection according to an embodiment. For example, FIG. 8 illustrates an example of the ESD protection device 13 of FIG. 1. As illustrated in FIG. 8, the device 80 may include a first circuit 81 and a second circuit 82 connected in parallel to each other between the first node N1 and the second node N2. Hereinafter, descriptions redundant to those of FIG. 2 will be omitted for convenience of description.

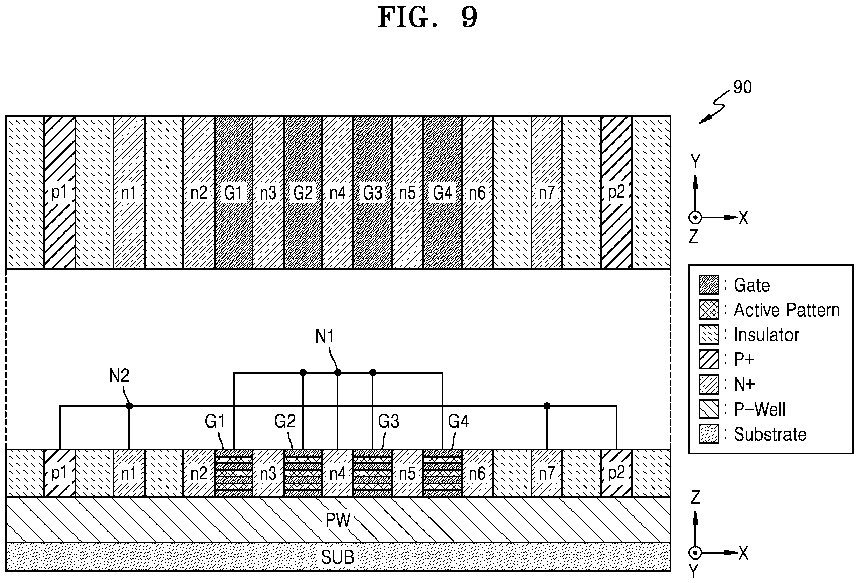

The first circuit 81 may include two first NFETs M11 and M12 and the first NPN BJT Q1. In the first circuit 81, the first NFET M1 included in the first circuit 21 of FIG. 2 may be replaced with the two first NFETs M11 and M12. As illustrated in FIG. 8, a gate and a drain of the first NFET M11 may be connected to the first node N1. A gate of the first NFET M12 may be connected to the first node N1, and a drain of the first NFET M12 may be connected to a source of the first NFET M11. As described below with reference to FIG. 9, a source of the first NFET M12 and the collector of the first NPN BJT Q 1 may correspond to one n+ region.

The second circuit 82 may include two second NFETs M21 and M22 and the second NPN BJT Q2. In the second circuit 82, the second NFET M2 included in the second circuit 22 of FIG. 2 may be replaced with the two second NFETs M21 and M22. As illustrated in FIG. 8, a gate and a drain of the second NFET M21 may be connected to the first node N1. A gate of the second NFET M22 may be connected to the first node N1, and a drain of the second NFET M22 may be connected to a source of the second NFET M21. As described below with reference to FIG. 9, a source of the second NFET M22 and the collector of the second NPN BJT Q2 may correspond to one n+ region.

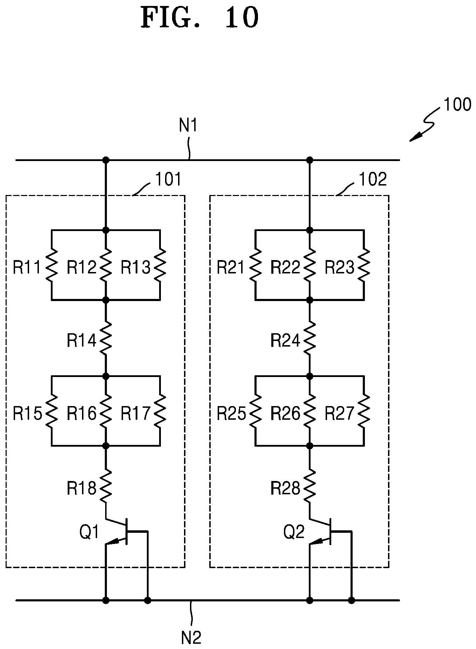

As described below with reference to FIG. 10, higher ballistic resistance may be provided due to the NFETs added to each of the first circuit 81 and the second circuit 82. Hereinafter, a layout including the device 80 of FIG. 8 will be described with reference to FIG. 9, and an equivalent circuit corresponding to the device 80 of FIG. 8 will be described with reference to FIG. 10.

FIG. 9 is a diagram illustrating a layout of a device according to an embodiment. For example, FIG. 9 illustrates a plan view and a cross-sectional view of a layout 90 including the first circuit 81 and the second circuit 82 of FIG. 8. For convenience of illustration, structures for connecting p+ regions, n+ regions, and gates to each other, for example, contacts, vias, and conductive patterns, are omitted. Hereinafter, FIG. 9 will be described with reference to FIG. 8.

Referring to FIG. 9, a p-well PW may be disposed in a substrate SUB. A first p+ region p1, first to seventh n+ regions n1 to n7, and a second p+ region p2 may be sequentially disposed in an X-axis direction on the p-well PW. In addition, a first gate G1 may be formed between the second n+ region n2 and the third n+ region n3, a second gate G2 may be formed between the third n+ region n3 and the fourth n+ region n4, a third gate G3 may be formed between the fourth n+ region n4 and the fifth n+ region n5, and a fourth gate G4 may be formed between the fifth n+ region n5 and the sixth n+ region n6. As illustrated in FIG. 9, the layout 90 may include three active patterns (e.g., three nanosheets) passing through each of the first to fourth gates G1 to G4 in the X-axis direction. The number of active patterns passing through a gate electrode is not limited to the illustration of FIG. 9.

The first p+ region p1, the first to seventh n+ regions n1 to n7, and the second p+ region p2 may extend in a Y-axis direction, and the first to fourth gates G1 to G4 may also extend in the Y-axis direction. An insulator may be disposed in a portion from which a gate is removed, and for example, an SDB may be disposed between doped regions (e.g., n+ regions and p+ regions) on the p-well PW.

The first NFET M11 of FIG. 8 may correspond to the second gate G2, the third n+ region n3, and the fourth n+ region n4, the first NFET M12 of FIG. 8 may correspond to the first gate G1, the second n+ region n2, and the third n+ region n3, and the first NPN BJT Q1 of FIG. 8 may correspond to the p-well PW, the first p+ region p1, the first n+ region n1, and the second n+ region n2. For example, the second gate G2 and the fourth n+ region n4, which are connected to the first node N1, may respectively correspond to the gate and the drain of the first NFET M11, and the third n+ region n3 may correspond to the source of the first NFET M11. The first gate G1 connected to the first node N1 may correspond to the gate of the first NFET M12, and the second n+ region n2 and the third n+ region n3 may respectively correspond to the source and the drain of the first NFET M12. Accordingly, the third n+ region n3 may be shared by the two first NFETs M11 and M12. In addition, the first n+ region n1 connected to the second node N2 may correspond to the emitter of the first NPN BJT Q1, the p-well PW, which is connected to the second node N2 through the first p+ region p1, may correspond to the base of the first NPN BJT Q1, and the second n+ region n2 may correspond to the collector of the first NPN BJT Q1. Accordingly, the second n+ region n2 may correspond to the source of the first NFET M12 and the collector of the first NPN BJT Q1 and may be shared by the first NFET M12 and the first NPN BJT Q1.

The second NFET M21 of FIG. 8 may correspond to the third gate G3, the fourth n+ region n4, and the fifth n+ region n5, the second NFET M22 of FIG. 8 may correspond to the fourth gate G4, the fifth n+ region n5, and the sixth n+ region n6, and the second NPN BJT Q2 of FIG. 8 may correspond to the p-well PW, the sixth n+ region n6, the seventh n+ region n7, and the second p+ region p2. For example, the third gate G3 and the fourth n+ region n4, which are connected to the first node N1, may respectively correspond to the gate and the drain of the second NFET M21, and the fifth n+ region n5 may correspond to the source of the second NFET M21. Accordingly, the fourth n+ region n4 may be shared by the first NFET M11 and the second NFET M21. The fourth gate G4 connected to the first node N1 may correspond to the gate of the second NFET M22, and the fifth n+ region n5 and the sixth n+ region n6 may respectively correspond to the drain and the source of the second NFET M22. Accordingly, the fifth n+ region n5 may be shared by the two second NFETs M21 and M22. In addition, the seventh n+ region n7 connected to the second node N2 may correspond to the emitter of the second NPN BJT Q2, the p-well PW, which is connected to the second node N2 through the second p+ region p2, may correspond to the base of the second NPN BJT Q2, and the sixth n+ region n6 may correspond to the collector of the second NPN BJT Q2. Accordingly, the sixth n+ region n6 may correspond to the source of the second NFET M22 and the collector of the second NPN BJT Q2 and may be shared by the second NFET M22 and the second NPN BJT Q2.

FIG. 10 is a circuit diagram illustrating a device 100 according to an embodiment. For example, the circuit diagram of FIG. 10 illustrates an equivalent circuit corresponding to the layout 90 of FIG. 9. As illustrated in FIG. 10, the device 100 may include a first circuit 101 and a second circuit 102 connected in parallel to each other between the first node N1 and the second node N2. Hereinafter, FIG. 10 will be described with reference to FIGS. 8 and 9.

The first circuit 101 may include resistors R11 to R18 and the first NPN BJT Q1. The resistors R11 to R18 may include three resistors R11, R12 and R13 connected in parallel to each other, a resistor R14, three resistors R15, R16 and R17 connected in parallel to each other, and a resistor R18. The three resistors R11 to R13 connected in parallel to each other may respectively correspond to the three active patterns (e.g., three nanosheets) passing through the second gate G2, and the resistor R14 may correspond to the third n+ region n3. In addition, the three resistors R15 to R17 connected in parallel to each other may respectively correspond to the three active patterns (e.g., three nanosheets) passing through the first gate G1, and the resistor R18 may correspond to the second n+ region n2. As described above with reference to FIG. 8, the two first NFETs M11 and M12 may provide ballistic resistance corresponding to the resistors R11 to R18.

The second circuit 102 may include resistors R21 to R28 and the second NPN BJT Q2. The resistors R21 to R28 may include three resistors R21, R22 and R23 connected in parallel to each other, a resistor R24, three resistors R25, R26 and R27 connected in parallel to each other, and a resistor R28. The three resistors R21 to R23 connected in parallel to each other may respectively correspond to the three active patterns (e.g., three nanosheets) passing through the third gate G3, and the resistor R24 may correspond to the fifth n+ region n5. In addition, the three resistors R25 to R27 connected in parallel to each other may respectively correspond to the three active patterns (e.g., three nanosheets) passing through the fourth gate G4, and the resistor R28 may correspond to the sixth n+ region n6. As described above with reference to FIG. 8, the two second NFETs M21 and M22 may provide ballistic resistance corresponding to the resistors R21 to R28.

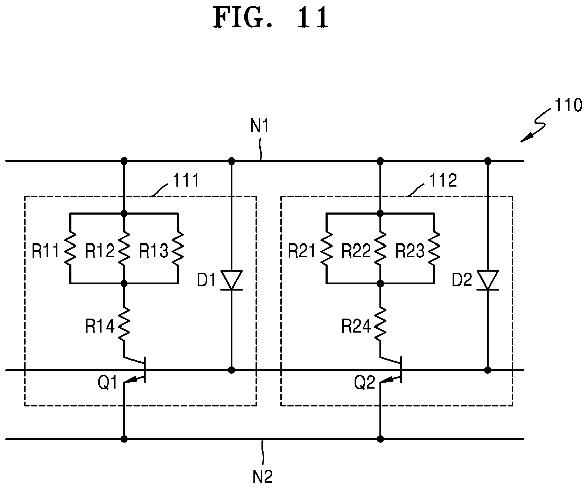

FIG. 11 is a circuit diagram illustrating a device 110 according to an embodiment. For example, the circuit diagram of FIG. 11 illustrates an equivalent circuit of the device 110. As illustrated in FIG. 11, the device 110 may include a first circuit 111 and a second circuit 112 connected in parallel to each other between the first node N1 and the second node N2. Hereinafter, descriptions of FIG. 11 that are redundant to those of FIG. 5 will be omitted for convenience of description.

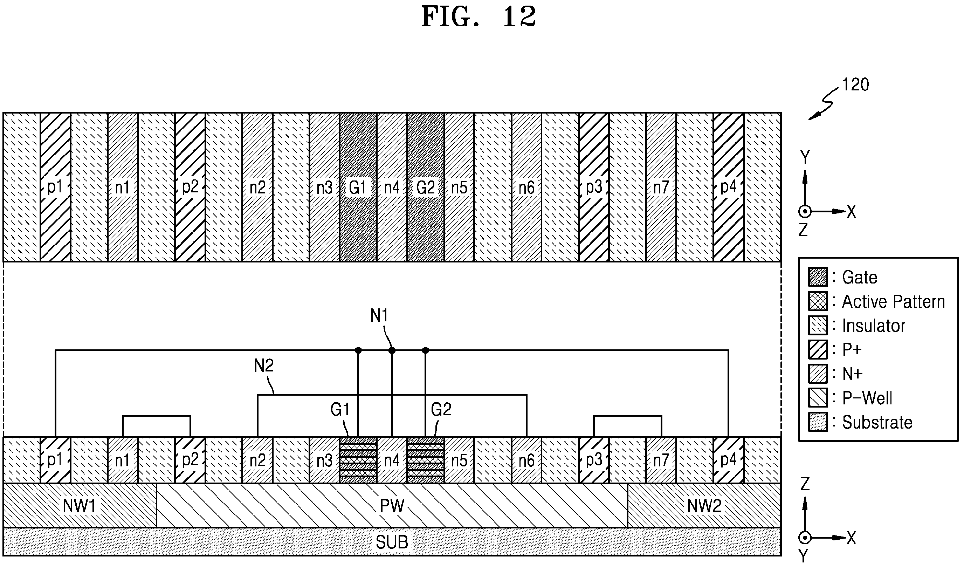

The first circuit 111 may include the resistors R11 to R14, the first NPN BJT Q1, and a first diode D1. The resistors R11, R12 and R13 connected in parallel to each other may correspond to three active patterns (e.g., three nanosheets) passing through a gate (e.g., G1 of FIG. 12), and the resistor R14 may correspond to an n+ region (e.g., n3 of FIG. 12) corresponding to the collector of the first NPN BJT Q1. The base of the first NPN BJT Q1 may be connected to a cathode of the first diode D1, instead of the second node N2.

Compared to the first circuit 51 of FIG. 5, the first circuit 111 may further include the first diode D1 having an anode connected to the first node N1 and a cathode connected to the base of the first NPN BJT Q1. When ESD occurs between the first node N1 and the second node N2, the first diode D1 may increase the potential of the base of the first NPN BJT Q1, and thus, the first NPN BJT Q1 may be driven early. That is, the trigger voltage of the first circuit 111 may be reduced by the first diode D1, and an internal circuit (e.g., 14 of FIG. 1) having a low operating voltage may be protected from the ESD.

The second circuit 112 may include the resistors R21 to R24, the second NPN BJT Q2, and a second diode D2. The resistors R21, R22 and R23 connected in parallel to each other may correspond to three active patterns (e.g., three nanosheets) passing through a gate (e.g., G2 of FIG. 12), and the resistor R24 may correspond to an n+ region (e.g., n5 of FIG. 12) corresponding to the collector of the second NPN BJT Q2. The base of the second NPN BJT Q2 may be connected to a cathode of the second diode D2, instead of the second node N2.

Compared to the second circuit 52 of FIG. 5, the second circuit 112 may further include the second diode D2 having an anode connected to the first node N1 and a cathode connected to the base of the second NPN BJT Q2. When ESD occurs between the first node N1 and the second node N2, the second diode D2 may increase the potential of the base of the second NPN BJT Q2, and thus, the second NPN BJT Q2 may be driven early. That is, the trigger voltage of the second circuit 112 may be reduced by the second diode D2, and an internal circuit (e.g., 14 of FIG. 1) having a low operating voltage may be protected from the ESD.

FIG. 12 is a diagram illustrating a layout of a device according to an embodiment. For example, FIG. 12 illustrates a plan view and a cross-sectional view of a layout 120 including the first circuit 111 and the second circuit 112 of FIG. 11. For convenience of illustration, structures for connecting p+ regions, n+ regions, and gates to each other, for example, contacts, vias, and conductive patterns, are omitted. Hereinafter, FIG. 12 will be described with reference to FIG. 11, and descriptions redundant to those provided above with reference to the drawings will be omitted for convenience of description.

Referring to FIG. 12, a first n-well NW1, a p-well PW, and a second n-well NW2 may be sequentially disposed in an X-axis direction in a substrate SUB. A first p+ region p1 and a first n+ region n1 may be disposed on the first n-well NW1, a second p+ region p2, second to sixth n+ regions n2 to n6, and a third p+ region p3 may be sequentially disposed in the X-axis direction on the p-well PW, and a seventh n+ region n7 and a fourth p+ region p4 may be disposed on the second n-well NW2. In addition, a first gate G1 may be formed between the third n+ region n3 and the fourth n+ region n4, and a second gate G2 may be formed between the fourth n+ region n4 and the fifth n+ region n5. As illustrated in FIG. 12, the layout 120 may include three active patterns (e.g., three nanosheets) passing through the first gate G1 in the X-axis direction and connected to the third n+ region n3 and the fourth n+ region n4, and may include three active patterns (e.g., three nanosheets) passing through the second gate G2 in the X-axis direction and connected to the fourth n+ region n4 and the fifth n+ region n5. The number of active patterns passing through a gate electrode is not limited to the illustration of FIG.12.

The first to fourth p+ regions p1 to p4 and the first to seventh n+ regions n1 to n7 may extend in a Y-axis direction, and the first gate G1 and the second gate G2 may also extend in the Y-axis direction. An insulator may be disposed in a portion from which a gate is removed between doped regions (e.g., n+ regions and p+ regions) on the first n-well NW1, the p-well PW and the second n-well NW2, and for example, an SDB may be disposed.

The resistors R11 to R13 of FIG. 11 may correspond to the three active patterns passing through the first gate G1, and the resistor R14 of FIG. 11 may correspond to the third n+ region n3. The first NPN BJT Q1 of FIG. 11 may correspond to the p-well PW, the second p+ region p2, the second n+ region n2, and the third n+ region n3. For example, the second n+ region n2 connected to the second node N2 may correspond to the emitter of the first NPN BJT Q1, the p-well PW, which is connected to the first n+ region n1 through the second p+ region p2, may correspond to the base of the first NPN BJT Q1, and the third n+ region n3 may correspond to the collector of the first NPN BJT Q1. The first p+ region p1 connected to the first node N1 may correspond to the anode of the first diode D1 of FIG. 11, and the first n-well NW1 may correspond to the cathode of the first diode D1. Accordingly, the first n-well NW1 may be connected to the p-well PW, that is, the base of the first NPN BJT Q1, through the first n+ region n1 and the second p+ region p2.

The resistors R21 to R23 of FIG. 11 may correspond to the three active patterns passing through the second gate G2, and the resistor R24 of FIG. 11 may correspond to the fifth n+ region n5. The second NPN BJT Q2 of FIG. 11 may correspond to the p-well PW, the fifth n+ region n5, the sixth n+ region n6, and the third p+ region p3. For example, the sixth n+ region n6 connected to the second node N2 may correspond to the emitter of the second NPN BJT Q2, the p-well PW, which is connected to the seventh n+ region n7 through the third p+ region p3, may correspond to the base of the second NPN BJT Q2, and the fifth n+ region n5 may correspond to the collector of the second NPN BJT Q2. The fourth p+ region p4 connected to the first node N1 may correspond to the anode of the second diode D2 of FIG. 11, and the second n-well NW2 may correspond to the cathode of the second diode D2. Accordingly, the second n-well NW2 may be connected to the p-well PW, that is, the base of the second NPN BJT Q2, through the seventh n+ region n7 and the third p+ region p3.

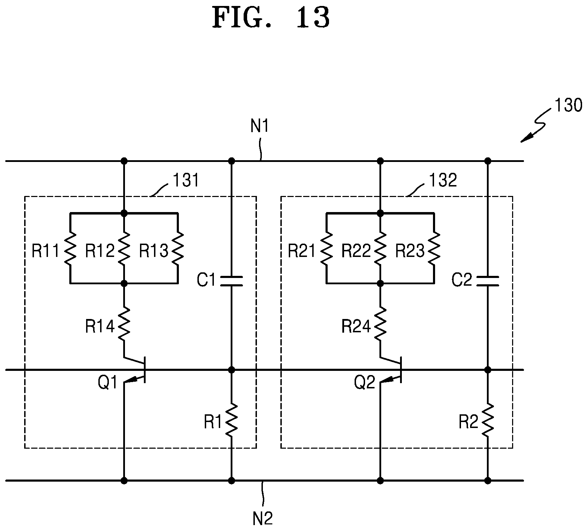

FIG. 13 is a circuit diagram illustrating a device 130 according to an embodiment. For example, the circuit diagram of FIG. 13 illustrates an equivalent circuit of the device 130. As illustrated in FIG. 13, the device 130 may include a first circuit 131 and a second circuit 132 connected in parallel to each other between the first node N1 and the second node N2. Hereinafter, descriptions of FIG. 13 that are redundant to those of FIG. 5 will be omitted for convenience of description.

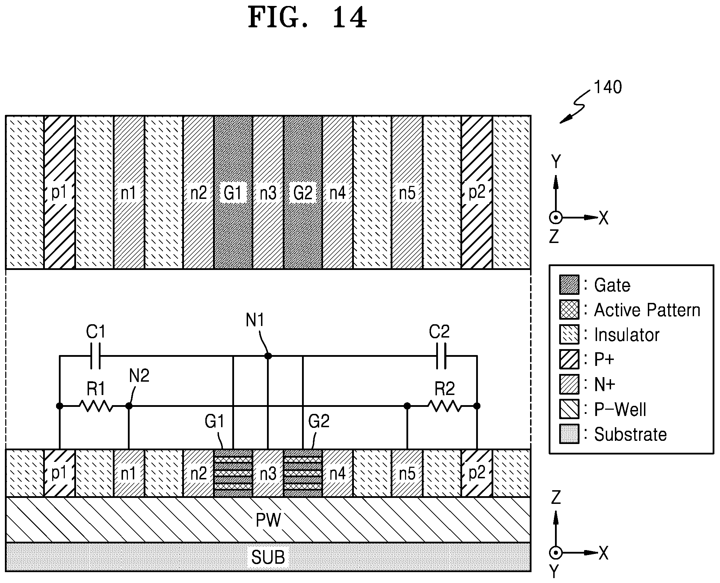

The first circuit 131 may include the resistors R11 to R14, the first NPN BJT Q1, a first capacitor C1, and a first resistor R1. The resistors R11, R12 and R13 connected in parallel to each other may correspond to three active patterns (e.g., three nanosheets) passing through a gate (e.g., G1 of FIG. 14), and the resistor R14 may correspond to an n+ region (e.g., n2 of FIG. 14) corresponding to the collector of the first NPN BJT Q1. The base of the first NPN BJT Q1 may be connected to a node at which the first capacitor C1 and the first resistor R1 are connected to each other, instead of the second node N2.

Compared to the first circuit 51 of FIG. 5, the first circuit 131 may further include the first capacitor C1 and the first resistor R1. When ESD occurs between the first node N1 and the second node N2, the potential of the base of the first NPN BJT Q1 may be increased by the first capacitor C1 connected to the first node N1, and thus, the first NPN BJT Q1 may be driven early. That is, the trigger voltage of the first circuit 131 may be reduced by the first capacitor C1 and the first resistor R1, and an internal circuit (e.g., 14 of FIG. 1) having a low operating voltage may be protected from the ESD.

The second circuit 132 may include the resistors R21, R22, R23 and R24, the second NPN BJT Q2, a second capacitor C2, and a second resistor R2. The resistors R21 to R23 connected in parallel to each other may correspond to three active patterns (e.g., three nanosheets) passing through a gate (e.g., G2 of FIG. 14), and the resistor R24 may correspond to an n+ region (e.g., n4 of FIG. 14) corresponding to the collector of the second NPN BJT Q2. The base of the second NPN BJT Q2 may be connected to a node at which the second capacitor C2 and the second resistor R2 are connected to each other, instead of the second node N2.

Compared to the second circuit 52 of FIG. 5, the second circuit 132 may further include the second capacitor C2 and the second resistor R2. When ESD occurs between the first node N1 and the second node N2, the potential of the base of the second NPN BJT Q2 may be increased by the second capacitor C2 connected to the first node N1, and thus, the second NPN BJT Q2 may be driven early. That is, the trigger voltage of the second circuit 132 may be reduced by the second capacitor C2 and the second resistor R2, and an internal circuit (e.g., 14 of FIG. 1) having a low operating voltage may be protected from the ESD.

FIG. 14 is a diagram illustrating a layout of a device according to an embodiment. For example, FIG. 14 illustrates a plan view and a cross-sectional view of a layout 140 including the first circuit 131 and the second circuit 132 of FIG. 13. For convenience of illustration, structures for connecting p+ regions, n+ regions, and gates to each other, for example, contacts, vias, and conductive patterns, are omitted. Hereinafter, FIG. 14 will be described with reference to FIG. 13, and descriptions redundant to those provided above with reference to the drawings will be omitted for convenience of description.

Referring to FIG. 14, a p-well PW may be disposed in a substrate SUB. A first p+ region p1, first to fifth n+ regions n1 to n5, and a second p+ region p2 may be sequentially disposed in an X-axis direction on the p-well PW. In addition, a first gate G1 may be formed between the second n+ region n2 and the third n+ region n3, and a second gate G2 may be formed between the third n+ region n3 and the fourth n+ region n4. As illustrated in FIG. 14, the layout 140 may include three active patterns (e.g., three nanosheets) passing through the first gate G1 in the X-axis direction and connected to the second n+ region n2 and the third n+ region n3, and may include three active patterns (e.g., three nanosheets) passing through the second gate G2 in the X-axis direction and connected to the third n+ region n3 and the fourth n+ region n4. The number of active patterns passing through a gate electrode is not limited to the illustration of FIG. 14.

The first p+ region p1, the first to fifth n+ regions n1 to n5, and the second p+ region p2 may extend in a Y-axis direction, and the first gate G1 and the second gate G2 may also extend in the Y-axis direction. An insulator may be disposed in a portion from which a gate is removed between doped regions (e.g., n+ regions and p+ regions) on the p-well PW, and for example, an SDB may be disposed.

The resistors R11 to R13 of FIG. 13 may correspond to the three active patterns passing through the first gate G1, and the resistor R14 of FIG. 13 may correspond to the second n+ region n2. The first NPN BJT Q1 of FIG. 13 may correspond to the p-well PW, the first p+ region p1, the first n+ region n1, and the second n+ region n2. For example, the first n+ region n1 connected to the second node N2 may correspond to the emitter of the first NPN BJT Q1, the p-well PW, which is connected to the first capacitor C1 and the first resistor R1 through the first p+ region p1, may correspond to the base of the first NPN BJT Q1, and the second n+ region n2 may correspond to the collector of the first NPN BJT Q1. The first capacitor C1 may be connected to the first node N1 and may be connected to the p-well PW, that is, the base of the first NPN BJT Q1, through the first p+ region p1. The first resistor R1 may be connected to the second node N2, and may be connected to the p-well PW, that is, the base of the first NPN BJT Q1, through the first p+ region p1.

The resistors R21 to R23 of FIG. 13 may correspond to the three active patterns passing through the second gate G2, and the resistor R24 of FIG. 13 may correspond to the fourth n+ region n4. The second NPN BJT Q2 of FIG. 13 may correspond to the p-well PW, the fourth n+ region n4, the fifth n+ region n5, and the second p+ region p2. For example, the fifth n+ region n5 connected to the second node N2 may correspond to the emitter of the second NPN BJT Q2, the p-well PW, which is connected to the second capacitor C2 and the second resistor R2 through the second p+ region p2, may correspond to the base of the second NPN BJT Q2, and the fourth n+ region n4 may correspond to the collector of the second NPN BJT Q2. The second capacitor C2 may be connected to the first node N1 and may be connected to the p-well PW, that is, the base of the second NPN BJT Q2, through the second p+ region p2. The second resistor R2 may be connected to the second node N2, and may be connected to the p-well PW, that is, the base of the second NPN BJT Q2, through the second p+ region p2.

As is traditional in the field of the inventive concept, embodiments are described, and illustrated in the drawings, in terms of functional blocks, units and/or modules. Those skilled in the art will appreciate that these blocks, units and/or modules are physically implemented by electronic (or optical) circuits such as logic circuits, discrete components, microprocessors, hard-wired circuits, memory elements, wiring connections, etc., which may be formed using semiconductor-based fabrication techniques or other manufacturing technologies. In the case of the blocks, units and/or modules being implemented by microprocessors or similar, they may be programmed using software (e.g., microcode) to perform various functions discussed herein and may optionally be driven by firmware and/or software. Alternatively, each block, unit and/or module may be implemented by dedicated hardware, or as a combination of dedicated hardware to perform some functions and a processor (e.g., one or more programmed microprocessors and associated circuitry) to perform other functions.

While the inventive concept has been particularly shown and described with reference to embodiments thereof, it will be understood that various changes in form and detail may be made therein without departing from the spirit and scope of the inventive concept as defined by the following claims.

## Claims

1. A device, comprising:
a first well having a first conductivity type;
a first gate electrode extending in a first horizontal direction on the first well;
a first region and a second region each having a second conductivity type and spaced apart from each other in a second horizontal direction on the first well,
wherein the first gate electrode is disposed between the first and second regions, and the second horizontal direction crosses the first horizontal direction;
a third region having the second conductivity type and spaced apart from the second region in the second horizontal direction on the first well; and
a fourth region having the first conductivity type and spaced apart from the third region in the second horizontal direction on the first well,
wherein the first gate electrode and the first region are electrically connected to a first node, and
the third region is electrically connected to a second node.

2. The device of claim 1, further comprising:
a fifth region having the second conductivity type and disposed between the second region and the third region on the first well.

3. The device of claim 2, wherein the fifth region is electrically connected to the second node.

4. The device of claim 2, further comprising:
a second gate electrode extending in the first horizontal direction between the second region and the fifth region on the first well,
wherein the second gate electrode is electrically connected to the first node.

5. The device of claim 1, further comprising:
a fifth region having the first conductivity type and disposed between the second region and the third region on the first well.

6. The device of claim 1, wherein the fourth region is electrically connected to the second node.

7. The device of claim 1, further comprising:
a second well having the second conductivity type;
a fifth region having the second conductivity type and spaced apart from the fourth region in the second horizontal direction on the second well; and
a sixth region having the first conductivity type and spaced apart from the fifth region in the second horizontal direction on the second well,
wherein the fifth region is electrically connected to the fourth region, and
the sixth region is electrically connected to the first node.

8. The device of claim 1, further comprising:
a resistor electrically connected between the third region and the fourth region; and
a capacitor electrically connected between the first node and the fourth region.

9. The device of claim 1, further comprising:
a fifth region having the second conductivity type and spaced apart from the first region in the second horizontal direction on the first well;
a second gate electrode extending in the first horizontal direction between the first region and the fifth region on the first well;
a sixth region having the second conductivity type and spaced apart from the fifth region in the second horizontal direction on the first well; and
a seventh region having the first conductivity type and spaced apart from the sixth region in the second horizontal direction on the first well,
wherein the second gate electrode is electrically connected to the first node, and
the sixth region is electrically connected to the second node.

10. The device of claim 9, further comprising:
an eighth region having the second conductivity type and disposed between the fifth region and the sixth region on the first well.

11. The device of claim 9, further comprising:
an eighth region having the first conductivity type and disposed between the fifth region and the sixth region on the first well.

12. The device of claim 9, wherein the seventh region is electrically connected to the second node.

13. The device of claim 9, further comprising:
a resistor connected between the sixth region and the seventh region; and
a capacitor connected between the first node and the seventh region.

14. The device of claim 1, further comprising:
a first diffusion break extending in the first horizontal direction between the second region and the third region on the first well; and
a second diffusion break extending in the first horizontal direction between the second region and the fourth region on the first well.

15. The device of claim 1, further comprising:
at least one first active pattern passing through the first gate electrode in the second horizontal direction and connected to the first region and the second region.
